# EUROPEAN PATENT APPLICATION

(11) **EP 3 128 822 A1**
(43) Date of publication of application: **08.02.2017**
(21) Application number: 14888346.5
(22) Date of filing: 20.05.2014
(51) Int. Cl.: H05K 7/14

(54) **BOARD INSTALLATION APPARATUS**

(30) Priority: 01.04.2014 CN 201420155954 U
(71) Applicant: ZTE Corporation, Shenzhen City, Guangdong Province 518057 (CN)
(72) Inventor: YE, Shuiming, Shenzhen Guangdong 518057 (CN); ZHANG, Sidong, Shenzhen Guangdong 518057 (CN); PAN, Qing, Shenzhen Guangdong 518057 (CN)
(74) Representative: Novagraaf Technologies
(86) International application number: PCT/CN2014/077918
(87) International publication number: WO 2015/149423

(57) **Abstract**

Provided is a board mounting device, including: a fixed plate, wherein at least one connecting piece is arranged on one surface of the fixed plate; a support plate for fixing a board, wherein the support plate is provided with at least one groove, which is in match with the at least one connecting piece and provides at least one movement track; and an adjusting device, configured to adjust the support plate to switch between a first state and a second state, wherein in the first state, the support plate is fixed relative to the fixed plate, and in the second state, the support plate is movable relative to the fixed plate. In the board mounting device, a support plate for fixing a board is configured to be movable relative to a fixed plate, and at least one guide groove in the support plate is configured to be movable relative to the fixed plate by means of at least one connecting piece, such that the support plate and the board fixed thereon can move together relative to the fixed plate. In this way, relative movement between the board and the fixed plate is realized, and the mounting and maintenance performances of the board are achieved.

## Description

### Technical Field

The present disclosure relates to a mounting device, and in particular to a board mounting device.

### Background

In most communication products with rack mount structures, it is often needed to frequently disassemble boards and sub-boards contained therein. As boards have extensible structures, the mounting and maintenance performances should be considered preferentially. The quality of a mounting device playing a key role in mounting and maintenance of a board directly affects the overall maintainability of a rack mount structure.

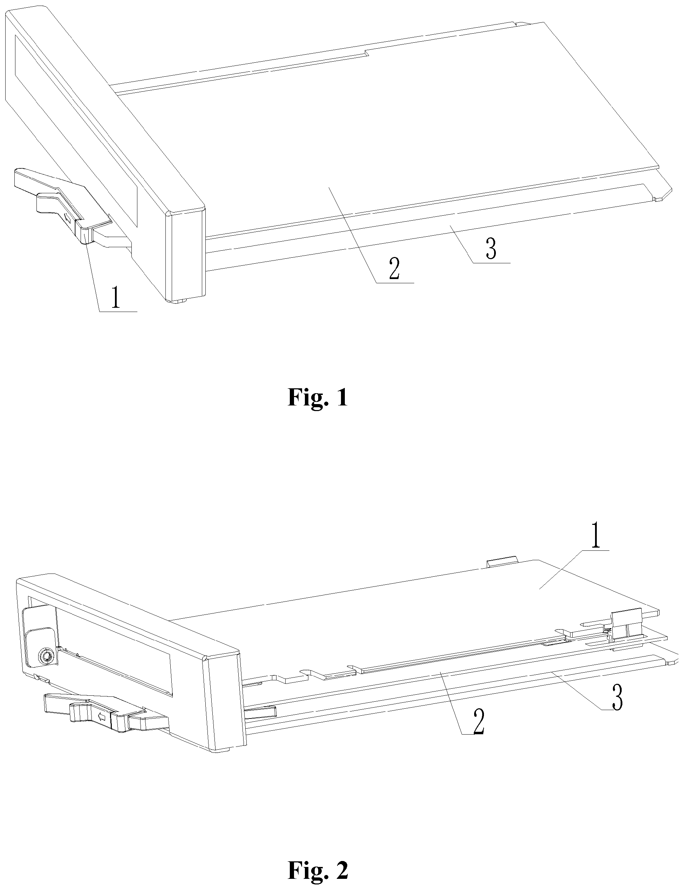

Fig. 1 and Fig. 2 show structural diagrams of the mount of a Printed Circuit Board (PCB) adopted in a related art. As shown in Fig. 1 and Fig. 2, a board 1 is fixed to a fixed plate 3 by means of a support plate 2, and the PCB is plugged horizontally, plugged vertically or plugged front and back, that is, the PCB is movable in only a single direction. Particularly, it is needed to maintain the PCB, plugged horizontally or vertically, by opening an upper cover plate of a product, however, when the product has been placed into a shelf or when other products are placed on the product, the upper cover plate cannot be opened for maintenance.

Thus, the board mounting device in the related art can only achieve movement of a board in one single direction, thereby affecting the maintenance of the board.

### Summary

The embodiments of the present disclosure solve the technical problem that after a board is mounted according to the related art, movement can only be achieved in a single direction, which affects the mounting and maintenance of the board. The embodiments of the present disclosure provide a board mounting device.

The technical solutions adopted by the embodiments of the present disclosure are introduced as follows. A board mounting device may include:
a fixed plate, wherein at least one connecting piece is arranged on one surface of the fixed plate;
a support plate for fixing a board, wherein the support plate is provided with at least one groove, which is in match with the at least one connecting piece and provides at least one movement track; and
an adjusting device, configured to adjust the support plate to switch between a first state and a second state, wherein in the first state, the support plate is fixed relative to the fixed plate, and in the second state, the support plate is movable relative to the fixed plate.

In an exemplary embodiment, each connecting piece may include a first part with a diameter in match with a width of the corresponding guide groove and a second part with a diameter larger than the width of the corresponding guide groove.

In an exemplary embodiment, the connecting piece may be a pin, and the diameter of an end of the pin is larger than the diameter of a body of the pin.

In an exemplary embodiment, an inlet in match with the second part of the pin may be provided on the corresponding guide groove.

In an exemplary embodiment, the guide groove may be U-shaped.

In an exemplary embodiment, a blocking piece configured to prevent the pin from disengagement may be arranged at the inlet of the guide groove.

In an exemplary embodiment, the blocking piece may be an elastic blocking piece.

In an exemplary embodiment, the adjusting device may be a puller, the puller may include a rotary shaft connected to the fixed plate and a connecting rod connected to the rotary shaft, and one end of the connecting rod may be connected to the support plate.

In an exemplary embodiment, the other end of the connecting rod may be connected to a clamping piece, the clamping piece having a first state in which the clamping piece is fixedly connected to the fixed plate and a second state in which the clamping piece is separated from the fixed plate.

In an exemplary embodiment, the board may be a PCB.

The embodiments of the present disclosure have the beneficial technical effects as follows. In the board mounting device of the embodiments of the present disclosure, a support plate for fixing a board is configured to be movable relative to a fixed plate, and at least one guide groove in the support plate is configured to be movable relative to the fixed plate by means of at least one connecting piece, such that the support plate and the board fixed thereon can move together relative to the fixed plate. In this way, relative movement between the board and the fixed plate is realized, and the mounting and maintenance performances of the board are achieved.

### Brief Description of the Drawings

Fig. 1 is a structural diagram of the mount of a PCB in the related art;
Fig. 2 is a structure diagram of assembly of a board in the related art;
Fig. 3 is a structural diagram of a board mounting device according to an embodiment of the present disclosure; and
Fig. 4 is a diagram of another view of Fig. 3.

### Detailed Description of the Embodiments

In order to make the technical problems to be solved by the embodiments of the present disclosure, the technical solutions and the advantages clearer, detailed descriptions will be made below in conjunction with the drawings and specific embodiments.

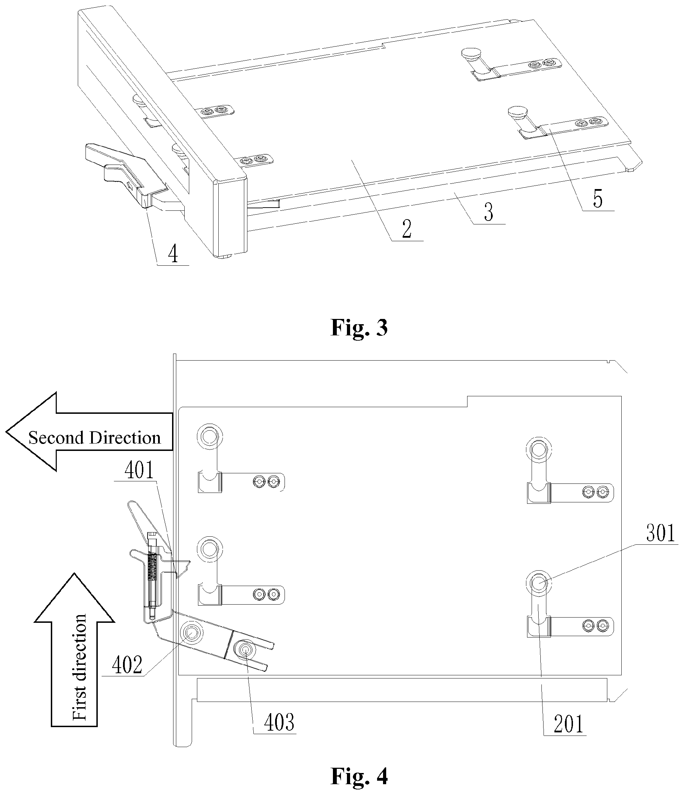

Fig. 3 and Fig. 4 show structural diagrams of a board mounting device according to an embodiment of the present disclosure. The mounting device of the present embodiment includes:
a fixed plate 3, wherein at least one connecting piece 301 is arranged on one surface of the fixed plate;
a support plate 2 for fixing a board 1 to be mounted, wherein one surface of the support plate is opposite to a surface, on which at least one connecting piece is provided, of the fixed plate, and the support plate is provided with at least one guide groove 201, which is in match with the at least one connecting piece and provides at least one movement track; and
an adjusting device 4, configured to adjust the support plate to switch between a first state and a second state, wherein in the first state, the support plate is fixed relative to the fixed plate, and in the second state, the support plate is movable relative to the fixed plate.

In the board mounting device of the embodiment of the present disclosure, a support plate is configured to be movable relative to a fixed plate, and at least one guide groove in the support plate is configured to be movable relative to the fixed plate by means of at least one connecting piece, such that the support plate and the board fixed thereon can move together relative to the fixed plate. In this way, relative movement between the board and the fixed plate is realized, and the mounting and maintenance performances of the board are achieved.

The board of the embodiment of the present disclosure may be any board to be fixedly mounted. The present embodiment is illustrated taking the PCB as an example, but the board should not be limited to the PCB.

The connecting piece 301 of the embodiment of the present disclosure is configured to be in matching connection with the guide groove 201 provided in the support plate. The connecting piece of the embodiment of the present disclosure may be a pin. When there are multiple connecting pieces (e.g., pins), the multiple connecting pieces are in one-to-one correspondence to multiple guide grooves provided in the support plate. As an exemplary implementation, four pins may be arranged at four corners of the fixed plate, and four guide grooves 201 are provided at the corresponding positions on the support plate. For each pin, a diameter of a first part of the pin, which may be a body part of the pin, is in match with the width of the corresponding guide groove, and a diameter of a second part of the pin, which may be an end part of the pin, is larger the width of the corresponding guide groove. When the end of the pin is clamped into the corresponding guide groove, the pin is prevented from disengaging from the corresponding guide groove in the support plate due to the fact that the diameter of the end of the pin is larger than the width of the corresponding guide groove.

With reference to Fig. 3 again, the guide groove 201 of the present embodiment may be U-shaped. An inlet in match with the end of the pin may be provided on the U-shaped groove, and an elastic blocking piece 5 may be arranged at the inlet and configured to prevent the pin from disengaging from the inlet. The U-shaped groove provides a track for movement of the pin, such that the pin can move along the U-shaped groove. Certainly, the track formed by the guide groove may also be arc-shaped or wavy.

The guide groove of the present embodiment is provided with the inlet in match with the end of the pin. Specifically, an inlet larger than the pin is provided at an end of the guide groove, such that the end of the pin can be conveniently clamped into the guide groove. In order to prevent the pin from sliding out of the inlet end when moving in the guide groove, an elastic blocking piece is arranged at the inlet. The elastic blocking piece may be made of plastic and metal, such that the pin can slide into the guide groove from the inlet, but cannot easily slide out of the guide groove.

The adjusting device 4 of the embodiment of the present disclosure is configured to adjust the support plate to switch between the first state and the second state, namely adjust into fixed connection between the support plate and the fixed plate or adjust into relative movement between the support plate and the fixed plate. The adjusting device of the present embodiment may be a puller, and may also be a component capable of adjusting the support plate to switch between the first state and the second state. The puller of the present embodiment may include a rotary shaft 402 connected to the fixed plate and a connecting rod connected to the rotary shaft. One end 403 of the connecting rod is connected to the support plate, and the other end of the connecting rod is configured to exert a force, for driving the connecting rod to rotate, on the connecting rod. The puller of the present embodiment supplies a thrust to the support plate by means of rotation of the connecting rod, such that the support plate moves relative to the fixed plate. Because the rotary shaft 402 is connected to the fixed plate, when the connecting rod moves along the rotary shaft, the support plate connected to the connecting rod can be driven, such that the support plate moves.

With reference to Fig. 4 again, the other end of the connecting rod of the present embodiment may be connected to a clamping piece 401, the clamping piece 401 having a first state in which the clamping piece is fixedly connected to the fixed plate and a second state in which the clamping piece is separated from the fixed plate. When the clamping piece is in the first state, the clamping piece is clamped on the fixed plate, such that the support plate and the fixed plate are fixed together. When the clamping piece is in the second state, the clamping piece is separated from the fixed plate, and in this case, the connecting rod can be driven to move along the rotary shaft by exerting a force on the connecting rod, such that the support plate fixed with a PCB can be driven to move relative to the fixed plate.

When the puller 4 is subjected to an upward acting force shown in Fig. 4, namely a first direction in Fig. 4, the clamping piece 401 moves up to relieve restriction, exerts a leftward acting force namely force in a second direction in Fig. 4, and the connecting rod rotates around the rotary shaft 402, such that the movable support plate 2 can be pushed to move, and the pins limit the movable support plate to be capable of only moving along the tracks set by the guide grooves.

In the technical solutions, a support plate for fixing a board is configured to be movable relative to a fixed plate, and at least one guide groove in the support plate is configured to be movable relative to the fixed plate by means of at least one connecting piece, such that the support plate and the board fixed thereon can move together relative to the fixed plate. In this way, relative movement between the board and the fixed plate is realized, and the mounting and maintenance performances of the board are achieved.

The above is only exemplary implementations of the present disclosure. It shall be pointed out that those skilled in the art can also make some improvements and modifications without departing from the principle of the present disclosure. These improvements and modifications shall fall within the protective scope of the present disclosure.

### Industrial applicability

The technical solutions provided by the embodiments of the present disclosure can be applied to a board mounting device. A support plate for fixing a board is configured to be movable relative to a fixed plate, and at least one guide groove in the support plate is configured to be movable relative to the fixed plate by means of at least one connecting piece, such that the support plate and the board fixed thereon can move together relative to the fixed plate. In this way, relative movement between the board and the fixed plate is realized, and the mounting and maintenance performances of the board are achieved.

## Claims

1. A board mounting device, comprising:
a fixed plate, wherein at least one connecting piece is arranged on one surface of the fixed plate;
a support plate for fixing a board, wherein the support plate is provided with at least one groove, which is in match with the at least one connecting piece and provides at least one movement track; and
an adjusting device, configured to adjust the support plate to switch between a first state and a second state, wherein in the first state, the support plate is fixed relative to the fixed plate, and in the second state, the support plate is movable relative to the fixed plate.

2. The board mounting device as claimed in claim 1, wherein each connecting piece comprises a first part with a diameter in match with a width of the corresponding guide groove and a second part with a diameter larger than the width of the corresponding guide groove.

3. The board mounting device as claimed in claim 2, wherein the connecting piece is a pin, and the diameter of an end of the pin is larger than the diameter of a body of the pin.

4. The board mounting device as claimed in claim 3, wherein an inlet in match with the second part of the pin is provided on the corresponding guide groove.

5. The board mounting device as claimed in claim 4, wherein the guide groove is U-shaped.

6. The board mounting device as claimed in claim 4, wherein a blocking piece configured to prevent the pin from disengagement is arranged at the inlet of the guide groove.

7. The board mounting device as claimed in claim 6, wherein the blocking piece is an elastic blocking piece.

8. The board mounting device as claimed in any one of claims 1 to 7, wherein the adjusting device is a puller, the puller comprises a rotary shaft connected to the fixed plate and a connecting rod connected to the rotary shaft, and one end of the connecting rod is connected to the support plate.

9. The board mounting device as claimed in claim 8, wherein the other end of the connecting rod is connected to a clamping piece, the clamping piece having a first state in which the clamping piece is fixedly connected to the fixed plate and a second state in which the clamping piece is separated from the fixed plate.

10. The board mounting device as claimed in any one of claims 1 to 7, wherein the board is a Printed Circuit Board, PCB.
